# FASCICULE DE BREVET EUROPEEN

(11) **EP 2 076 617 B1**
(45) Date de publication et mention de la délivrance du brevet: **10.05.2017**
(21) Numéro de dépôt: 07858555.1
(22) Date de dépôt: 11.10.2007
(51) Int. Cl.: C23C 14/06, C23C 14/48

(54) **COUCHE DE CUIVRE COMPRENANT DES ATOMES D'AZOTE INSERES, PROCEDE D'IMPLANTATION ASSOCIE**
SCHICHT AUS KUPFER ODER KUPFER MIT GERINGEM LEGIERUNGSANTEIL MIT INTEGRIERTEN STICKSTOFFATOMEN UND ENTSPRECHENDES BEARBEITUNGSVERFAHREN
COPPER OR LOW-ALLOY COPPER LAYER WITH INSERTED NITROGEN ATOMS AND RELATED PROCESSING METHOD

(30) Priorité: 11.10.2006 FR 0608889
(43) Date de publication de la demande: 08.07.2009
(73) Titulaire: Quertech, 14000 Caen (FR)
(72) Inventeur: BUSARDO, Denis, 14510 Gonneville/mer (FR)
(74) Mandataire: Cabinet Plasseraud
(86) Numéro de dépôt international: PCT/FR2007/052125
(87) Numéro de publication internationale: WO 2008/043964

(56) Documents cités:
- WO-A-2005/085491
- JP-A- 63 019 714
- THOME ET AL: "Depth profiling of carbon and nitrogen in copper using nuclear reactions" NUCLEAR INSTRUMENTS & METHODS IN PHYSICS RESEARCH, SECTION - B: BEAM INTERACTIONS WITH MATERIALS AND ATOMS, ELSEVIER, AMSTERDAM, NL, vol. 249, no. 1-2, août 2006 (2006-08), pages 377-380, XP005552120 ISSN: 0168-583X
- LIU B X ET AL: "THERMODYNAMICS AND GROWTH KINETICAL CONSIDERATION OF METAL-NITRIDE FORMATION BY NITROGEN IMPLANTATION" PHYSICA STATUS SOLIDI (A). APPLIED RESEARCH, BERLIN, DE, vol. 113, no. 1, 16 mai 1989 (1989-05-16), pages 11-22, XP009052027 ISSN: 0031-8965
- SANCHEZ G ET AL: "Thermal effect of ion implantation with ultra-short ion beams" SURFACE AND COATINGS TECHNOLOGY SWITZERLAND, vol. 70, no. 2-3, 1 janvier 1995 (1995-01-01), pages 181-186, XP002478129 ISSN: 0257-8972

## Description

L'invention a pour objet une couche de cuivre ou d'alliage de cuivre faiblement allié comprenant des atomes d'azote insérés, ainsi qu'un procédé de traitement d'un alliage de cuivre faiblement allié, en vu d'obtenir une telle couche.

L'invention vise également une pièce comprenant au moins une partie à la surface de laquelle est disposée une telle couche.

A ce titre elle met en oeuvre un dispositif de nitruration par implantation ionique d'une pièce en alliage de cuivre faiblement allié à partir d'un faisceau d'ions d'azote émis par une source d'ions. L'invention a également pour objet un procédé de nitruration d'une pièce en alliage de cuivre faiblement allié mettant en oeuvre un tel dispositif.

L'invention trouve des applications par exemple dans le domaine des circuits électriques et/ou électroniques, dans le domaine électrique et/ou électrotechnique où il est souvent souhaitable de traiter des connecteurs en cuivre ou en alliage de cuivre faiblement allié pour réduire la résistance de contact et supprimer les risques de grippage.

On définit la résistance de contact entre deux métaux, par la résistance électrique due à l'imperfection de la jonction entre ces deux métaux.

Les raisons d'une résistance de contact sont divisées fondamentalement en deux catégories: celles pouvant être évitées et celles qui sont inéluctables.

Les raisons inéluctables sont celles dues à la rugosité inhérente aux surfaces: le contact n'est pas parfait, la conduction électrique s'effectue au travers de points de contacts répartis de façon discontinue sur la surface.

Les raisons évitables sont liées à la présence de couches isolantes du à la pollution de l'air ou à des particules (poussières). Les particules de poussière peuvent provenir du processus de fabrication ou encore de l'abrasion provoquée par le mouvement des contacts. Les couches isolantes se divisent quant à elles en deux catégories : les couches inorganiques provenant de la corrosion ou de l'oxydation, les couches organiques dues par exemple aux graisses

L'état de contacts recouvert d'une couche isolante peut être classifié en trois catégories :
1. L'isolement : la tension appliquée n'est pas suffisante pour démarrer la conduction électrique.
2. L'effet de cohérence : la tension appliquée atteint un seuil ou se produit un effondrement de la résistance de contact et le démarrage de la conduction électrique.
3. Contact métallique : la pression des contacts est suffisante pour détruire mécaniquement la couche isolante.

Les connecteurs en cuivre pur présentent un avantage lié à leur très haute conductivité électrique du cuivre (la deuxième après l'argent) mais présentent deux inconvénients majeurs :
1. La fragilité : le cuivre n'est pas très dur et a pour particularité de se rayer et de s'user assez rapidement lors de frottements répétés. Les poussières produites par abrasion et la multiplication des points de contacts due aux rayures ont pour effet de diminuer la surface de contact donc d'augmenter la résistance de contact.
2. Son oxydabilité dans le temps : une fine couche isolante d'oxyde cuivrique et cuivreux se forme sur la surface du cuivre pur, ce qui a pour effet d'augmenter la résistance de contact jusqu'à rendre un connecteur inopérant (isolement de l'état de contact).

L'industrie électrique utilise en conséquence peu le cuivre pur pour les inconvénients exposés plus haut mais plutôt des cuivres faiblement alliés. On définit de manière usuelle les cuivres dits « faiblement alliés » comme des alliages de cuivre comprenant au plus 2,5 pourcent en poids, voire au plus 1 pourcent en poids d'éléments d'addition, c'est-à-dire comprenant au moins 97,5% en poids de cuivre. Leurs caractéristiques mécaniques sont supérieures à celles du cuivre pur et ils conservent des caractéristiques électriques élevées.

Les principaux sont : le cuivre à l'argent (en général de 0,03 à 0,10 pourcent en poids d'argent) dont les caractéristiques mécaniques sont conservées à une température plus élevée de 100° C que celle du cuivre pur ; le cuivre au cadmium (en général de 0,7 à 1 pourcent en poids de Cd) dont la conductivité atteint 88 pourcent de celle du cuivre pur pour une résistance mécanique plus élevée ; le cuivre au tellure (en général de 0,5 à 0,9 pourcent en poids de Te), cuivre de décolletage dont la conductivité atteint 98 pourcent de celle du cuivre ; le cuivre au chrome (en général de 0,5 à 0,9 pourcent en poids de Cr) est un alliage dit à durcissement structural ; le cuivre au béryllium (en général de 1,8 à 2% en poids de Be), alliage à durcissement structural qui possède des caractéristiques mécaniques remarquables équivalentes à celle des outils ; sa conductivité atteint 25 % de celle du cuivre pur. Il existe également des cuivres faiblement alliés à l'étain (Sn), au soufre (S), au plomb (Pb), au Zirconium (Zr), au Chrome Zirconium (Cr-Zr), au fer phosphore (Fe-P), au cobalt phosphore (Co-P), au nickel silicium (Ni-Si), au cobalt béryllium (Co-Be), à l'alumine (Al₂O₃), à l'oxyde de titane (TiO₂).

D'autres alliages existent et les éléments ci-dessus mentionnés peuvent être combinés, de même que des impuretés peuvent être présentes en général à une teneur inférieure ou égale à 0,1 % en poids.

On reste dans le cadre de la définition d'un alliage de cuivre faiblement allié, tant que l'alliage comprend une teneur supérieure ou égale à 97,5% en poids de cuivre.

Une sous classe d'alliages de cuivre faiblement alliés regroupe les alliages des cuivres où la teneur en cuivre est supérieure ou égale à 99 % en poids.

Le cuivre au béryllium permet en particulier de nombreuses applications dans le domaine électrique : contacts, connecteurs, rupteurs, etc.

La dureté du cuivre ou des alliages de cuivre faiblement alliés varie en général entre 40 et 150 HV (dureté Vickers) pour les alliages de cuivre comprenant Cd, Ag, Sn, Te, S, Pb, Cr, Zr, P, Fe, Co, Al₂O₃, TiO₂ et où la teneur minimale en cuivre est de 97,5 pourcent en poids. La dureté d'alliages de cuivre faiblement alliés peut atteindre entre 200 et 400 HV (dureté Vickers) pour les alliages de cuivre comprenant Si ou Be et où la teneur minimale en cuivre est de 97,5 % en poids.

Ces alliages de cuivres faiblement alliés constituent un bon compromis entre dureté mécanique et conductivité électrique, mais sont remplacés par l'or dés qu'il s'agit d'avoir une conductivité électrique proche du cuivre pour laquelle la formation d'une couche d'oxyde n'est pas à craindre. L'or pur ne s'oxyde pas mais présente toutefois des faiblesses sur le plan mécanique, car c'est un métal mou.

La recherche sur le « *connecteur idéal* » est actuellement très active : on mène, par exemple, des analyses des régimes de décroissance de la résistance électrique de contact en fonction de la force sous faibles courants et faibles tensions : matériaux classiques (Au, Ag, Pd, Sn), nouveaux revêtements (AgC, Carbon Se), nouveaux matériaux tel les polymères conducteurs « Metallized Particules Interconnect, MPI ». Ces technologies ont toutes leurs avantages et leurs inconvénients en termes de coût, de performance électrique et de fiabilité dans la durée.

Aujourd'hui l'industrie électrique vise dans l'absolu à fabriquer des connecteurs, notamment pour automobile, qui puissent résister aux contraintes électriques, climatiques et mécaniques sans dégradation de leurs résistances de contact. Ces connecteurs doivent présenter un bon coefficient de frottement, être durs superficiellement, avoir des conductivités proches du cuivre pur, être peu sensibles à l'oxydation et peu sujets au grippage. Ces caractéristiques ont pour but de garantir de faibles résistances de contact sur une longue durée. D'autre part, l'implantation multi-énergie dans le cuivre est connue, par exemple de T. Thomé, "Depth profiling of carbon and nitrogen in copper using nuclear reactions, Nucl. Inst. and Methods in Phys. Res. B 249 (2006) 377-380. L'invention a pour but de remédier aux inconvénients et problèmes des techniques exposées précédemment.

Il est notamment visé par la présente invention de proposer une couche de cuivre ou d'alliage de cuivre faiblement allié dont la dureté superficielle et la cinétique d'oxydation sont améliorées et qui permet de garantir de faibles résistances de contact sur une longue durée.

Ce but est atteint par une couche de cuivre ou d'alliage de cuivre faiblement allié comprenant des atomes d'azote telle que définie dans la revendication 1.

On entend par « cuivre » un métal comprenant au moins 99,9 % en poids de cuivre, voire au moins 99,99 % en poids. A titre d'exemple, on peut citer parmi les « cuivres », le Cu-a, Cu-b, Cu-c.

Il en résulte du cuivre ou des alliages de cuivre faiblement alliés dont la dureté superficielle est améliorée et dont le coefficient de frottement est diminué.

En outre, ce cuivre ou ces alliages de cuivre faiblement alliés présentent une oxydation consécutive à une exposition à l'air et à l'eau considérablement ralentie. Les risques de grippage entre deux surfaces de contact antagonistes de ces matériaux sont considérablement réduits. La conductivité électrique en surface de ces matériaux est très proche de celle de cuivre ou des alliages de cuivre d'origine. Cet effet est obtenu par la méthode définie par la revendication 9. Selon différents modes de réalisation, qui peuvent notamment être combinés :
- la concentration atomique maximale, N/(Cu+N), est supérieure ou égale à 5 %, par exemple supérieure ou égale à 10 %, voire supérieure ou égale à 20 % sur une épaisseur supérieure ou égale à 0,05 µm ;
- la concentration atomique N/(Cu+N) est inférieure ou égale à 75 %, par exemple inférieure ou égale à 50 % sur l'ensemble de la profondeur de la couche de cuivre ou d'alliage comprenant des atomes d'azote insérés ;
- le profil de concentration de l'azote en fonction de l'épaisseur de la couche est une courbe résultant de la somme d'au moins deux courbes gaussiennes ;
- la largeur à quart de hauteur du profil de concentration de l'azote est supérieure ou égale à 0,05 µm, par exemple supérieure ou égale à 0,1 µm, même par exemple supérieure ou égale à 0,2 µm, voire supérieure ou égale à 0,4 µm ;
- le profil de concentration de l'azote présente un plateau sur une profondeur supérieure ou égale à 0,1 µm, par exemple supérieure ou égale à 0,2 µm ;
- la composition de la couche de cuivre ou d'alliage de cuivre faiblement allié, exprimée en pourcentage pondéral, est définie par les plages de composition suivantes :

| | |
|---|---|
| Cuivre (Cu) | ≥ 97,5 ; |
| Oxygène (O) | 0 à 0,5 ; de préférence ≤ 0,1 ; |
| Cadmium (Cd) | 0 à 2,5 ; de préférence ≤ 1 ; |
| Argent (Ag) | 0 à 2,5 ; de préférence ≤ 0,5 ; par exemple ≤ 0,1 ; |
| Etain (Sn) | 0 à 2,5 ; de préférence ≤ 0,5 ; par exemple ≤ 0,15 ; |
| Tellure (Te) | 0 à 2,5 ; de préférence ≤ 1 ; |
| Soufre (S) | 0 à 2,5 ; de préférence ≤ 1 ; |
| Plomb | 0 à 2,5 ; de préférence ≤ 1 ; |
| Chrome (Cr) | 0 à 2,5 ; de préférence ≤ 1 ; |
| Zirconium (Zr) | 0 à 2,5 ; de préférence ≤ 0,2 ; |
| Phosphore (P) | 0 à 2,5 ; de préférence ≤ 0,1 ; |
| Fer (Fe) | 0 à 2,5 ; de préférence ≤ 1,5 ; |
| Cobalt (Co) | 0 à 2,5 ; de préférence ≤ 1 ; |
| Silicium (Si) | 0 à 2,5 ; de préférence ≤ 1 ; |
| Béryllium (Be) | 0 à 2,5 ; de préférence ≤ 2 ; |
| Alumine (Al₂O₃) | 0 à 2,5 ; de préférence ≤ 1 ; |
| Oxyde de titane (TiO₂) | 0 à 2,5 ; de préférence ≤ 1 ; |
| Autres éléments | 0 à 0,5 ; de préférence ≤ 0,1. |

On constate que la dureté est très significativement augmentée à partir de 5% de concentration atomique d'azote, qu'elle augmente sensiblement linéairement jusqu'à 30%, puis que la courbe d'augmentation de dureté s'infléchit entre sensiblement 30% et 50% de concentration atomique d'azote.

A titre d'exemple, pour un cuivre à 99,99% en poids, on peut atteindre une nano-dureté de l'ordre de 3,3 GPa pour une concentration d'azote de 25 %, une nano-dureté de l'ordre de 5,3 GPa pour une concentration atomique d'azote de 38 %, et on peut escompter une nanodureté de l'ordre de 5 à 6 GPa pour 50% de concentration atomique d'azote. La nano-dureté de l'échantillon avant traitement a été mesurée à 1,3 GPa.

Dans certains cas, on peut constater des défauts si la concentration atomique d'azote dépasse 75%, voire parfois 50%.

De manière générale, l'implantation d'ions mono énergie conduit à une courbe de répartition des ions en fonction de l'épaisseur, dite profil de concentration, de forme sensiblement gaussienne. Il est possible d'obtenir des profils de concentration résultant de la somme d'au moins deux courbes gaussiennes en implantant des ions d'énergies différentes qui pénètrent à des profondeurs différentes.

Les couches de cuivre ou d'alliage de cuivre faiblement allié présentant les caractéristiques ci-dessus sont remarquable en ce que leur dureté est considérablement augmentée en comparaison d'une couche de cuivre ou d'alliage de cuivre faiblement allié de même composition d'alliage dépourvue d'atomes d'azote insérés.

On constate en outre, que ces couches sont particulièrement résistantes à la corrosion et permettent ainsi de conserver sur de très longues périodes de temps des conductivités de surface voisines de celles du cuivre ou de l'alliage quand on crée une surface neuve.

Selon l'invention, on dénomme « épaisseur », une partie d'une couche située sensiblement perpendiculairement à sa surface extérieure.

L'épaisseur peut viser une distance à partir de ladite surface, tout comme une distance à partir d'un point situé sous ladite surface.

La concentration d'azote N/(Cu+N) est choisie par exemple de manière à obtenir une dureté désirée en fonction de paramètres liés notamment au temps de traitement, au coût du traitement.

On dénomme largeur à quart de hauteur la largeur du profil de concentration mesuré pour une concentration atomique d'azote égale au quart de la valeur maximale de la concentration d'azote dudit profil.

On note qu'un profil de concentration d'azote peut être mesuré expérimentalement, par exemple en utilisant une méthode de mesure connue par ESCA.

L'invention porte également sur une pièce comprenant au moins une partie à la surface de laquelle est disposée une couche de cuivre ou d'alliage de cuivre faiblement allié selon les modes de réalisation précédents.

Selon un mode de réalisation, la pièce ou une partie de la pièce est en cuivre ou en alliage de cuivre faiblement allié de même composition que la couche de cuivre ou d'alliage de cuivre faiblement allié comprenant des atomes d'azote et est en continuité de matière avec ladite pièce ou ladite partie de la pièce.

Selon un autre mode de réalisation, la pièce est au moins partiellement revêtue de cuivre ou d'un alliage de cuivre faiblement allié et la couche de cuivre ou d'alliage de cuivre faiblement allié comprenant des atomes d'azote est de même composition et en continuité de matière avec ledit revêtement.

Une telle pièce peut notamment, mais de manière non limitative, être une pièce d'un dispositif électrotechnique ou d'un circuit électrique et/ou électronique.

De manière avantageuse, la pièce comprend au moins une surface de contact en cuivre ou alliage de cuivre faiblement allié tel que défini précédemment.

L'invention vise également une pièce comprenant au moins une partie à la surface de laquelle est disposée une couche de cuivre ou d'un alliage de cuivre faiblement allié dont la composition est définie par les plages des teneurs des constituants majeurs suivants, exprimées en pourcentages pondéraux :

| | |
|---|---|
| Cuivre (Cu) | ≥ 97,5 ; |
| Oxygène (O) | 0 à 0,5 ; de préférence ≤ 0,1 ; |
| Cadmium (Cd) | 0 à 2,5 ; de préférence ≤ 1 ; |
| Argent (Ag) | 0 à 2,5 ; de préférence ≤ 0,5 ; par exemple ≤ 0,1 ; |
| Etain (Sn) | 0 à 2,5 ; de préférence ≤ 0,5 ; par exemple ≤ 0,15 ; |
| Tellure (Te) | 0 à 2,5 ; de préférence ≤ 1 ; |
| Soufre (S) | 0 à 2,5 ; de préférence ≤ 1 ; |
| Plomb | 0 à 2,5 ; de préférence ≤ 1 ; |
| Chrome (Cr) | 0 à 2,5 ; de préférence ≤ 1 ; |
| Zirconium (Zr) | 0 à 2,5 ; de préférence ≤ 0,2 ; |
| Phosphore (P) | 0 à 2,5 ; de préférence ≤ 0,1 ; |
| Fer (Fe) | 0 à 2,5 ; de préférence ≤ 1,5 ; |
| Cobalt (Co) | 0 à 2,5 ; de préférence ≤ 1 ; |
| Alumine (Al₂0₃) | 0 à 2,5 ; de préférence ≤ 1 ; |
| Oxyde de titane (Ti0₂) | 0 à 2,5 ; de préférence ≤ 1 ; |

où le pourcentage d'autres constituants est inférieur ou égal à 0,1, comprenant des atomes d'azote et dont la nano-dureté de surface est supérieure ou égale à 2 GPa, par exemple supérieure ou égale à 4 GPa, et/ou la dureté Vickers est supérieure ou égale à 200 pour une charge de 5 g, voir 50 g.

Selon un mode de réalisation de ladite pièce, la composition de l'alliage de cuivre faiblement allié peut comprendre également les constituants majeurs suivants dont la teneur est exprimée en pourcentages pondéraux :

| | |
|---|---|
| Silicium (Si) | 0 à 2,5 ; de préférence ≥ 0,5 ; et/ou de préférence ≤ 1 ; |
| Béryllium (Be) | 0 à 2,5 ; de préférence ≥ 0,5 ; et/ou de préférence ≤ 2 ; |

et la nano-dureté de surface est supérieure ou égale à 5 GPa et/ou la durée Vickers est supérieure ou égale à 500 pour une charge de 5 g, voire de 50 g.

De manière remarquable, une telle dureté dépasse les valeurs de dureté connues du cuivre ou d'un alliage de cuivre faiblement allié, même écrouis.

L'invention concerne également un procédé de traitement d'un alliage de cuivre faiblement allié comprenant une étape d'implantation d'ions d'azote, émis par une source d'énergie supérieure ou égale à 10 keV (kilo électron volt) par exemple supérieure ou égale à 20 keV, même par exemple supérieure ou égale à 30 keV, voire supérieure ou égale à 50 keV.

Selon différents modes de réalisation, qui peuvent notamment être combinés :
- les ions d'azote implantés sont des ions multi énergies constitués de N+, N2+, N3+, N4+, et de N5+ ;
- la source est une source à résonance cyclotronique électronique (RCE) ;
- la source à résonance cyclotronique électronique délivre des ions accélérés par une tension d'extraction et des premiers moyens de réglage d'un faisceau initial d'ions émis par ladite source en un faisceau d'implantation ;
- les ions d'azote multi énergies sont implantés simultanément à une profondeur contrôlée par la tension d'extraction de la source.

De manière générale, on constate que des faibles énergies, notamment entre 10 et 20 keV, peuvent conduire à augmenter les phénomènes de pulvérisation des atomes de cuivre en surface. Ce phénomène peut être avantageusement mis à profit pour obtenir une surface dépourvue de rugosités. Si on souhaite limiter les phénomènes de pulvérisation et/ou implanter profondément les ions d'azote, on aura tendance à augmenter leur énergie et on peut envisager des énergies par exemple de l'ordre de 100 ou 200 keV pour les ions N+. Dans le cas d'une source RCE, émettant des ions N+ à N5+, l'énergie des ions N2+, N3+, N4+, N5+ sera respectivement double, triple, quadruple, quintuple.

Sans vouloir être lié par une quelconque théorie scientifique, on peut penser que l'implantation d'ions d'azote multi-énergies produits par une source d'ions RCE à l'intérieur de laquelle de l'azote a été préalablement introduit et implanter les ions produits simultanément dans la pièce en cuivre ou en alliage de cuivre engendre des ions d'azote en interstitiel dans la structure du cuivre et/ou des microcristaux de nitrure de cuivre susceptibles d'introduire à leur tour une augmentation de la dureté. L'implantation simultanée de ces ions d'azote peut se faire à des profondeurs variables, en fonction des besoins et de la forme de la pièce. Ces profondeurs dépendent des énergies d'implantation des ions du faisceau d'implantation ; elles peuvent varier par exemple de 0 à environ 1 µm.

L'utilisation d'une source RCE présente en outre l'avantage complémentaire suivant par rapport à l'implantation effectuée avec un faisceau d'ions d'azote mono-énergie : pour une même concentration d'ions implantés, on peut favoriser avec un faisceau d'ions d'azote multi-énergies l'apparition de nitrure de cuivre ; l'implantation simultanée d'ions multi-énergies peut engendrer par collisions et cascades un brassage efficace des différentes couches de nitrure de cuivre (qui s'étagent à différentes profondeurs d'implantation dans l'épaisseur traitée). L'efficacité des processus de fragmentation et de dispersion des microcristaux dont sont constituées les couches de nitrure de cuivre peuvent permettre un accroissement supplémentaire de dureté grâce à l'implantation avec un faisceau d'ions d'azote multi-énergies.

L'invention concerne également le traitement d'une pièce comprenant au moins une partie à la surface de laquelle est disposée une couche de cuivre ou d'alliage de cuivre faiblement allié et où ladite couche de cuivre ou d'alliage de cuivre faiblement allié est traitée.

Selon différents modes de réalisation :
- les ions d'azote sont des ions multi énergies et sont implantés dans la pièce à une température inférieure ou égale à 300°C, voire inférieure à 200°C, par exemple inférieure à 100°C ;
- le faisceau d'ions, notamment multi énergies, se déplace de façon relative par rapport à la pièce, par exemple à vitesse constante ou par exemple à une vitesse variable tenant compte de l'angle d'incidence du faisceau d'ions, par rapport à la surface de la pièce où est disposée la couche de cuivre ou d'alliage de cuivre faiblement allié à traiter.

L'implantation des atomes d'azote peut se faire à basse température, par exemple à une température inférieure ou égale à 300°C, ce qui peut permettre de conserver une structure métallurgique, notamment un écrouissage et/ou un durcissement structural, de la pièce à traiter. Il est même possible de traiter une pièce à des températures inférieures ou égales à 100°C, par exemple entre 50 et 60°C.

L'invention sera détaillée ci-après à l'aide d'exemples non limitatifs, notamment illustrés par les figures suivantes :
La figure 1 représente un diagramme fonctionnel d'un dispositif mis en oeuvre dans un mode de réalisation du procédé selon l'invention.
Les figures 2 à 5 représentent des exemples de distribution d'ions implantés dans le cuivre selon différents modes de réalisation du procédé de la présente invention, où l'on porte la variation de la concentration atomique d'azote N/(Cu+N) en fonction de la profondeur de la couche de cuivre (exprimée en Angström, A).

Selon un mode de réalisation non limitatif, le traitement d'une pièce en cuivre ou en alliage de cuivre faiblement allié se fait par implantation simultanée d'ions multi-énergies. Ces derniers sont par exemple, obtenus en extrayant avec une même et unique tension d'extraction des ions mono- et multi-chargés créés dans la chambre à plasma d'une source d'ions à résonance cyclotronique électronique (source RCE). Dans ce cas, chaque ion produit par ladite source présente une énergie qui est proportionnelle à son état de charge. Il en découle que les ions dont l'état de charge est le plus élevé, donc d'énergie la plus élevée, s'implantent dans la pièce en alliage de cuivre faiblement allié faiblement allié à des profondeurs plus importantes.

On notera à ce stade de la description que cette implantation est rapide et peu coûteuse puisqu'elle ne nécessite pas une tension d'extraction élevée de la source d'ions. En effet, pour augmenter l'énergie d'implantation d'un ion, il est économiquement préférable d'augmenter son état de charge plutôt que d'augmenter sa tension d'extraction.

On notera également que ce dispositif permet de traiter une pièce sans altérer ses propriétés mécaniques obtenues par écrouissage et/ou durcissement structural (par exemple en traitant une pièce à une température inférieure à 300°C, et même par exemple à une température inférieure à 100°C).

Ledit dispositif d'implantation d'ions dans une pièce en cuivre ou en alliage de cuivre faiblement allié comporte une source délivrant des ions accélérés par une tension d'extraction et des premiers moyens de réglage d'un faisceau initial d'ions émis par ladite source en un faisceau d'implantation.

Un tel dispositif est principalement reconnaissable en ce que ladite source est une source à résonance cyclotronique électronique produisant des ions multi-énergies qui sont implantés dans la pièce, par exemple à une température inférieure à 300°C ou même 100°C, l'implantation des ions du faisceau d'implantation étant effectuée simultanément à une profondeur contrôlée par la tension d'extraction de la source.

Plus particulièrement, un mode de réalisation du procédé selon l'invention propose d'utiliser des ions d'azote multi-énergies produits par la source d'ions RCE à l'intérieur de laquelle de l'azote a été préalablement introduit et d'implanter les ions produits simultanément dans la pièce en cuivre ou en alliage de cuivre faiblement allié.

Compte tenu d'un effet de pulvérisation différent selon l'énergie donc l'état de charge de l'ion incident, on n'obtient pas le même profil de concentration d'ions implantés selon, par exemple, que l'on implante simultanément N+, N2+, N3+, ou que l'on implante successivement par état de charge d'ordre croissant N+, N2+, puis N3+, ou encore que l'on implante successivement par état de charge d'ordre décroissant N3+, N2+, puis N+. Selon ce mode de réalisation, l'implantation successive par état de charge d'ordre croissant donne un profil d'épaisseur large mais de faible concentration. L'implantation successive par état de charge d'ordre décroissant donne un profil d'épaisseur étroite mais de forte concentration. L'implantation simultanée est un compromis entre les deux types d'implantation précédents, on obtient un profil d'épaisseur moyenne et de concentration moyenne. Il est coûteux en termes de temps d'implanter des ions successivement par ordre croissant et décroissant. Un mode de réalisation du procédé de l'invention préconise l'implantation simultanée d'ions multi-énergies avec un faisceau multi-énergies et est de ce fait à la fois avantageux techniquement et avantageux sur le plan du compromis physique obtenu (profil de concentration équilibré). Il est possible d'obtenir un profil de concentration comportant un plateau de large épaisseur, dont on peut contrôler la hauteur.

L'augmentation de la dureté du cuivre ou de l'alliage de cuivre faiblement allié est notamment liée à la concentration en ions d'azote implantés.

Dans une application à des pièces en cuivre ou en alliage de cuivre faiblement allié, le procédé de l'invention permet d'obtenir une dureté superficielle très élevée et une excellente résistance à la corrosion.

Le dispositif utilisé comporte en outre avantageusement des deuxièmes moyens de réglage de la position relative de la pièce et de la source d'ions. On comprendra qu'un déplacement relatif entre la source d'ions et la pièce peut être mis en oeuvre pour pouvoir traiter cette dernière.

Selon une forme de réalisation du dispositif utilisé dans la présente invention dans laquelle la pièce est mobile par rapport à la source, les deuxièmes moyens de réglage comportent un porte-pièce qui est mobile pour déplacer la pièce au cours de son traitement. Dans une autre forme de réalisation du dispositif, c'est la source d'ions qui est déplacée par rapport à la pièce à traiter ; cette dernière forme de réalisation pouvant être mise en oeuvre lorsque les pièces à traiter représentent ensemble un poids trop important.

Le porte-pièce est par exemple équipé de moyens de refroidissement pour évacuer la chaleur produite dans la pièce lors de l'implantation des ions multi-énergies.

Les premiers moyens de réglage du faisceau d'ions comportent accessoirement un spectromètre de masse pour trier les ions produits par la source en fonction de leur charge et de leur masse.

Les premiers moyens de réglage du faisceau initial d'ions peuvent comporter des moyens optiques de focalisation, un profileur, un transformateur d'intensité et un obturateur.

Le dispositif peut être confiné dans une enceinte équipée d'une pompe à vide.

Les deuxièmes moyens de réglage de la position relative de la pièce et de la source d'ions peuvent comporter des moyens de calcul de cette position à partir d'informations relatives à la nature du faisceau d'ions, à la géométrie de la pièce, à la vitesse de déplacement du porte-pièce par rapport à la source et au nombre de passes précédemment réalisées.

Selon un mode de réalisation, le traitement du cuivre ou de l'alliage de cuivre faiblement allié par implantation ionique met en oeuvre un faisceau d'ions multi-énergies qui se déplace de façon relative par rapport à la pièce à une vitesse constante.

Selon un autre mode de réalisation, le faisceau d'ions multi-énergies se déplace de façon relative par rapport à la pièce à une vitesse variable tenant compte de l'angle d'incidence du faisceau d'ions multi-énergies par rapport à la surface de la pièce.

La vitesse de déplacement relative entre la pièce à traiter et la source d'ion peut être constante ou variable en fonction de l'angle d'incidence du faisceau par rapport à la surface, par exemple pendant la durée de traitement. La vitesse peut dépendre du débit du faisceau, du profil de concentration des ions implantés et du nombre de passes. La vitesse peut varier en fonction de l'angle d'incidence du faisceau par rapport à la surface, par exemple pour compenser la faiblesse de la profondeur d'implantation par une augmentation du nombre d'ions implantés.

Le faisceau d'ions multi-énergies peut être émis avec un débit et des énergies d'émission qui sont constants et commandés par la source d'ions. Comme expliqué précédemment, le procédé de l'invention peut permettre d'agir sur les profondeurs de pénétration des ions multi-énergies dans la pièce. Ces profondeurs de pénétration, qui peuvent s'étager dans l'épaisseur traitée, peuvent varier en fonction des différentes énergies d'entrée des ions au niveau de la surface de la pièce.

Sans vouloir être lié par une quelconque théorie scientifique, on peut penser que l'implantation des ions d'azote dans la structure cristalline de la pièce à traiter a pour effet d'insérer des ions d'azote en interstitiel et possiblement de créer des microcristaux de nitrure de cuivre (au delà d'une certaine concentration d'azote dans le cuivre) extrêmement durs qui bloquent les plans de glissement des dislocations à l'origine des déformations du matériau. En d'autres termes, le fait d'implanter des ions d'azote dans la pièce à traiter permet d'augmenter la dureté superficielle de la pièce et notamment de la rendre ainsi très résistante à l'usure.

Le procédé selon l'invention peut également permettre, par le phénomène de pulvérisation superficielle induit par le passage des ions incidents, de gommer les micro-rugosités de la pièce, autrement dit d'améliorer l'état de surface.

Le procédé selon l'invention permet en outre de réduire considérablement la corrosion des espèces atomiques composant l'alliage, en implantant sous la surface une barrière d'atomes d'azote, susceptible notamment de neutralisation des acides. Le procédé est ainsi susceptible d'empêcher l'oxydation du cuivre ou des alliages de cuivre faiblement allié.

Il résulte de ces dispositions que le procédé selon l'invention permet de traiter efficacement des pièces en cuivre ou en alliage de cuivre faiblement allié.

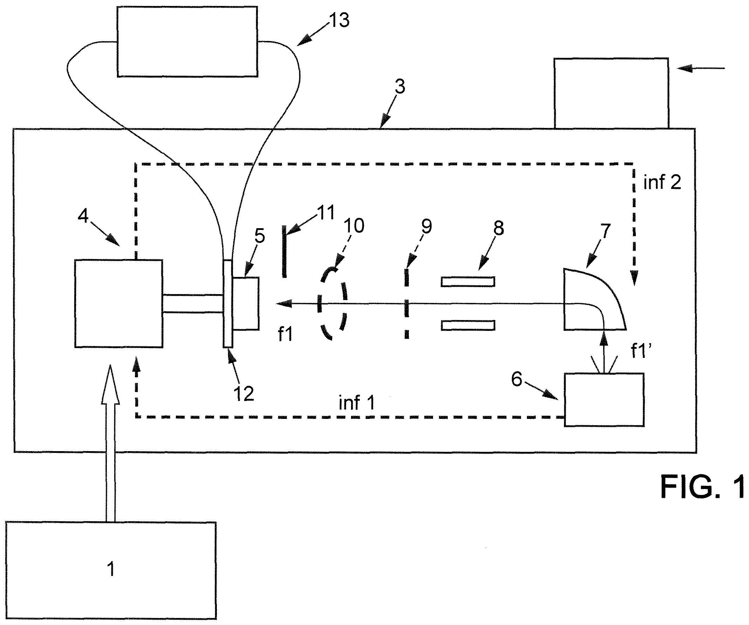

Sur la figure 1, un dispositif mis en oeuvre dans un mode de réalisation du procédé selon la présente invention est placé dans une enceinte 3 mise sous vide grâce à une pompe à vide 2. Ce vide a pour but d'empêcher l'interception du faisceau par des gaz résiduels et d'éviter la contamination de la surface de la pièce par ces mêmes gaz lors de l'implantation.

Ce dispositif comporte une source d'ions 6 à résonance cyclotronique électronique, dite source RCE. Cette source RCE 6 délivre un faisceau initial f1' d'ions multi-énergies d'azote pour un courant total d'environ 7,5 mA (toutes charges confondues N+, N2+, etc.), sous une tension d'extraction pouvant varier de 20 KV à 200 KV. La source RCE 6 émet le faisceau d'ions f1' en direction de premiers moyens de réglage 7-11 qui assurent la focalisation et le réglage du faisceau initial f1' émis par la source RCE 6 en un faisceau f1 d'implantation d'ions qui vient frapper une pièce à traiter 5.

Ces premiers moyens de réglage 7-11 comportent, de la source RCE 6 vers la pièce 5, les éléments suivants :
- un spectromètre de masse 7 apte à filtrer les ions en fonction de leur charge et de leur masse. Cet élément est facultatif ; en effet, dans le cas ou l'on injecte un gaz d'azote pur (N2), il est possible de récupérer l'ensemble des ions d'azote mono et multi-chargés produits par la source pour obtenir un faisceau d'ions d'azote multi-énergies. Le spectromètre de masse étant un élément très cher on réduit fortement le coût du dispositif en utilisant un faisceau d'ions d'azote multi-énergies obtenus à partir d'un gaz d'azote pur livré en bouteille.
- des lentilles 8 dont le rôle est de donner au faisceau initial f1' d'ions une forme choisie, par exemple cylindrique, avec un rayon choisi.
- un profileur 9 dont le rôle est d'analyser l'intensité du faisceau dans un plan de coupe perpendiculaire. Cet instrument d'analyse devient facultatif dès lors que les lentilles 8 sont réglées définitivement lors de la première implantation.
- un transformateur d'intensité 10 qui mesure en continu l'intensité du faisceau initial f1' sans l'intercepter. Cet instrument a pour fonction essentielle de détecter toute interruption du faisceau initial f1' et de permettre l'enregistrement des variations d'intensité du faisceau f1 durant le traitement.
- un obturateur 11 qui peut être une cage de Faraday, dont le rôle est d'interrompre la trajectoire des ions à certains moments, par exemple lors d'un déplacement sans traitement de la pièce.

Selon un mode de réalisation du dispositif utilisé dans le cadre du procédé selon l'invention et représentée sur la figure 1, la pièce 5 est mobile par rapport à la source RCE 6. La pièce 5 est montée sur un porte-pièce mobile 12 dont le déplacement est commandé par une machine à commande numérique 4, elle-même pilotée par un post-processeur calculé par un système de CFAO (conception et fabrication assistées par ordinateur) 1.

Le déplacement de la pièce 5 prend en compte le rayon du faisceau f1, les contours externes et internes des zones à traiter de la pièce 5, une vitesse de déplacement constante, ou variable en fonction de l'angle du faisceau f1 par rapport à la surface et un nombre de passes précédemment réalisées.

Des informations de contrôle (inf1) sont transmises de la source RCE 6 vers la machine à commande numérique 4. Ces informations de contrôle concernent l'état du faisceau. En particulier, la source RCE 6 informe la machine 4 lorsque le faisceau f1 d'ions est prêt à être envoyé. D'autres informations de contrôle (inf2) sont transmises par la machine 4 à l'obturateur 11, à la source RCE 6 et, éventuellement, à une ou plusieurs machines extérieures au dispositif. Ces informations de contrôle peuvent être les valeurs du rayon du faisceau d'ions, son débit et toutes autres valeurs connues de la machine 4.

Par ailleurs, le porte-pièce 12 est équipé d'un circuit de refroidissement 13 pour évacuer la chaleur produite dans la pièce 5 lors de l'implantation des ions multi-énergies.

Le fonctionnement dudit dispositif est le suivant :
- on bride la pièce à traiter 5 sur le porte-pièce 12,
- on ferme l'enceinte 3 abritant le dispositif,
- on met éventuellement en marche le circuit de refroidissement 13 du porte-pièce 12,
- on met en marche la pompe à vide 2 de manière à obtenir un vide poussé dans l'enceinte 3,
- dès que les conditions de vide sont atteintes, on procède à la production et au réglage du faisceau f1' d'ions grâce aux moyens de réglage 7-11,
- lorsque le faisceau est réglé, on lève l'obturateur 11 et on lance la machine à commande numérique 4 qui exécute alors le déplacement en position et en vitesse de la pièce 5 devant le faisceau en une ou plusieurs passes,
- lorsque le nombre de passes requis est atteint, on baisse l'obturateur 11 pour couper le faisceau f1, on arrête la production du faisceau f1', on casse le vide en ouvrant l'enceinte 3 à l'air ambiant, on arrête éventuellement le circuit de refroidissement 13 et on sort la pièce traitée 5 hors de l'enceinte 3.

Il existe deux manières de diminuer le pic en température lié au passage du faisceau f1 en un point donné de la pièce 5: augmenter le rayon du faisceau (donc réduire la puissance par cm²) ou augmenter la vitesse de déplacement.

Si la pièce est trop petite pour évacuer par rayonnement la chaleur liée au traitement on peut soit diminuer la puissance du faisceau f1 (donc augmenter la durée de traitement), soit mettre en marche le circuit de refroidissement 13 logé dans le porte pièce 12.

D'autres dispositifs sont susceptibles de permettre la mise en oeuvre du procédé selon la présente invention. On peut notamment envisager un dispositif de traitement d'une bande de cuivre ou d'alliage de cuivre faiblement allié en continu (usuellement dit du type « *wheel to wheel* » ) comprenant des moyens de défilement de la bande, un sas d'entrée et un sas de sortie pour délimiter une chambre de traitement où on atteint par exemple un vide de 10⁻³ mbar, une colonne de vide différentiel s'interposant entre la chambre de traitement et la source, notamment une source RCE, pour atteindre localement un vide de 10⁻⁶ mbar. Selon un mode de réalisation, la bande défile en continu sous le faisceau à une vitesse telle que la température reste inférieure à une à une valeur donnée et de manière à éviter des tensions excessives. Le traitement peut se faire en une ou plusieurs passe(s). Dans le cas d'une pluralité de passages, le nombre de passe est calculé pour atteindre la concentration requise.

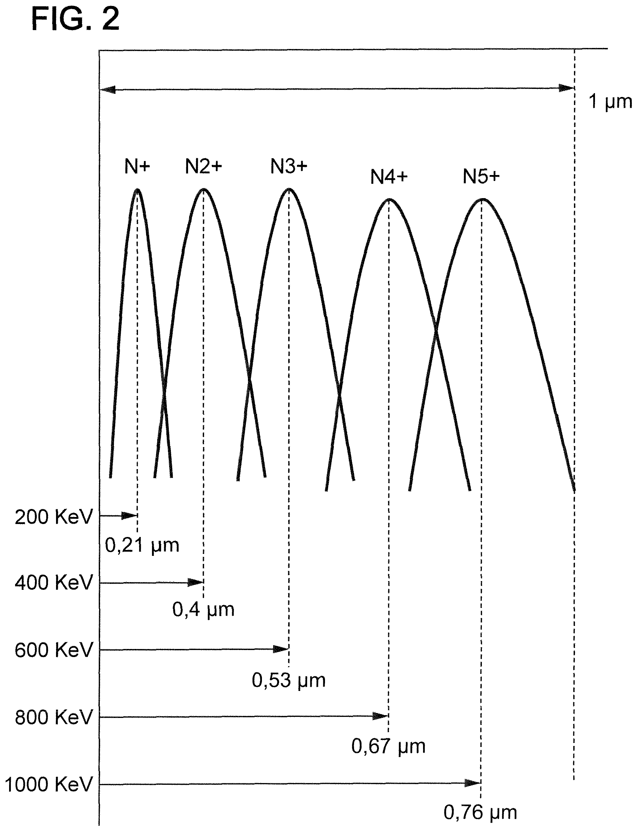

La figure 2 représente un exemple de distribution d'ions d'azote N implantés dans de le cuivre. Dans cet exemple, la source d'ions est une source RCE et délivre des ions N+, N2+, N3+, N4+ et N5+ qui sont tous extraits avec une seule et unique tension d'extraction, par exemple, de 200 KV. Ainsi les ions N+ émis par la source d'ions ont une énergie de 200 KeV, les ions N2+ ont une énergie de 400 KeV, les ions N3+ ont une énergie de 600 KeV, les ions N4+ ont une énergie de 800 KeV et les ions N5+ ont une énergie de 1000 KeV.

Dans ces exemples, on ne tient pas en compte de la pulvérisation qui a pour effet de faire glisser ces distributions vers l'extrême surface. Dans le cas présent, ces distributions ont l'allure de gaussiennes caractérisées par des profondeurs d'implantation moyennes (relatives à l'énergie d'implantation des ions) et un écart type propre à la nature statistique du parcours des ions dans la matière.

Les ions N+ atteignent une profondeur de 0,21 µm +/-0.07 µm. Les ions N2+ atteignent une profondeur d'environ 0,4 µm +/- 0,1 µm, les ions N3+ une profondeur d'environ 0.53 µm +/- 0,13 µm, les ions N4+ une profondeur d'environ 0.67 µm +/- 0,13 µm et les ions N5+ une profondeur d'environ 0.76 µm +/- 0,15 µm. La distance maximale atteinte par des ions dans cet exemple est d'environ 1µm.

La spécificité d'une source d'ions RCE 6 réside dans le fait qu'elle délivre des ions mono- et multi-chargés ce qui permet d'implanter simultanément des ions multi-énergies avec la même tension d'extraction. Il est ainsi possible d'obtenir simultanément sur toute l'épaisseur traitée un profil d'implantation plus ou moins bien réparti.

On obtient pour le profil d'implantation une répartition optimale en réglant les fréquences de la source 6 de manière à avoir une distribution équirépartie des états de charge des ions de la source (même nombre d'ions N+, N2+, N3+, N4+, N5+ par cm² et par seconde).

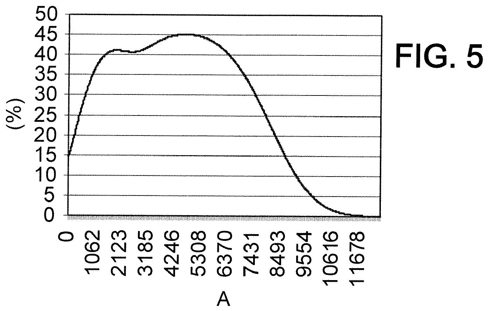

Par exemple, en reprenant l'exemple précédent, si l'on considère une source RCE délivrant un courant total de 7,5 mA (0,5 mA pour N+, 1 mA pour N2+, 1,5 mA pour N3+, 2 mA pour N4+, 2,5 mA pour N5+) avec une tension d'extraction de 200 KV, dans du cuivre et sur 1 cm2, pendant environ 300 secs, le profil d'implantation représenté sur la figure 5 comporte un plateau constant de 42 % dans une épaisseur comprise entre 0.15 µm et 0,75 µm.

Pour une même concentration d'ions implantés, on peut penser que l'effet physique en termes de dureté obtenue par implantation simultanée d'ions multi-énergies est supérieur à celui obtenu par implantation d'ions mono-énergie. En effet, la dispersion des microcristaux de nitrure de cuivre due à l'efficacité du brassage des ions multi-énergies (qui s'implantent à des profondeurs étagées), est susceptible d'induire un accroissement supplémentaire de dureté qui peut s'ajouter à celle qui serait obtenue avec un faisceau d'ions mono-énergies.

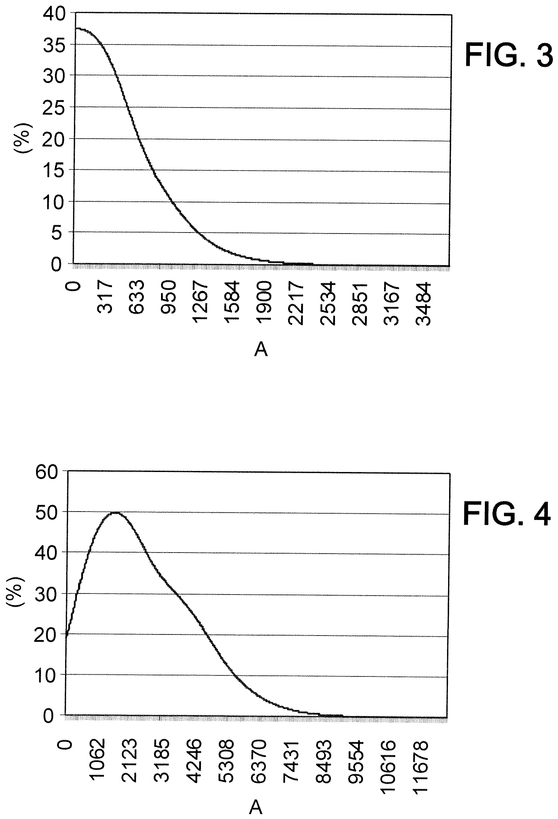

La figure 3 représente le profil de concentration atomique obtenu avec un faisceau présentant les caractéristiques suivantes : N+(2.5mA), N2+(2,8mA), N3+(1,2mA), N4+(0,25mA), N5+(0,04mA), une tension d'extraction de 35 KV. Le faisceau est concentré sur une surface de 1 cm² pendant 30 secondes. Ce profil représente en ordonnée la concentration atomique N/(Cu+N), en %, d'ions azote implantés en fonction de la profondeur d'implantation exprimée en Angström. La concentration atomique maximale est de 38 % environ (environ 1 atome d'azote pour deux atomes de cuivre) et est observée à la surface du matériau. Cette distribution est le résultat d'une somme de concentrations atomiques relatives à N+, N2+ et en moindre proportion à N3+. La pulvérisation de la surface produite par les ions N+, N2+, N3+ provoque un glissement de la concentration globale vers la surface, expliquant d'une part son asymétrie, d'autre part le point concentration atomique maximale de 38 %. La profondeur d'implantation maximale est de 0.19 µm environ. La largeur à quart de hauteur est de l'ordre de 1.02 µm, pour une concentration atomique d'azote d'environ 14,5 %.

La figure 4 représente un profil de concentration atomique N/(N+Cu), en %, en fonction de la profondeur d'implantation en Angstrom, obtenu avec un faisceau où les intensités sont les mêmes que celles du faisceau précédent, mais où la tension d'extraction est de 200 KV, et le faisceau est concentré sur une surface de 1 cm² pendant 100 secondes. La pulvérisation étant moins forte, on atteint une concentration atomique maximale de 50% (un atome d'azote pour un atome de cuivre). La profondeur d'implantation est d'environ 0.84 µm, soit 4 à 5 fois celle obtenue à 35 KV. La largeur à quart de hauteur est de l'ordre de 0.53 µm, pour une concentration atomique d'azote d'environ 12.5 %.

La figure 5 représente un profil de concentration atomique, N/(N+Cu),en %, qui peut conduire à des propriétés particulièrement avantageuses, en fonction de la profondeur d'implantation en Angstrom, obtenu avec un faisceau d'ions multichargés et équirépartis où : N+(0,5mA), N2+(1mA), N3+(1,5mA), N4+(2mA), N5+(2,5mA), la tension d'extraction est de 200 KV, et le faisceau est concentré sur une surface de 1 cm² pendant 300 secondes. L'équipartition des états de charge de l'azote permet d'obtenir un plateau large de concentration maximale d'environ 42 % (environ 1 atome d'azote pour un atome de cuivre) sur une épaisseur d'environ 6000 Angstrom. La profondeur d'implantation maximale est de l'ordre de 1,1 µm. La largeur à quart de hauteur est de l'ordre de 0.90 µm, pour une concentration atomique d'azote d'environ 11,3 %.

A titre d'exemples, des échantillons ont été réalisés où du cuivre à 99,99 % a été traité selon un mode de réalisation de l'invention, en insérant des ions d'azote émis par une source RCE de manière à obtenir le profil de concentration de la figure 3.

Des échantillons ainsi traités ont fait l'objet de mesures de nanodureté. On entend par mesure de nanodureté, des mesures effectuées avec un nanoduromètre selon une méthodologie connue de l'homme du métier. Dans le cas présent, une pointe Vickers a été utilisée, la mesure a été effectuée à température ambiante, une charge de 10 grammes a été appliquée et la pointe reste en contact 15 secondes à la surface de l'échantillon. Dix points de mesure ont été effectués sur une même zone. On obtient une valeur moyenne de 3,3 GPa pour les zones où l'azote a été implanté à hauteur d'une concentration atomique de 25 % et de 5,3 GPa pour des zones où l'azote a été implanté à hauteur d'une concentration atomique de 38 %. A titre de comparaison, la dureté d'une partie non traitée est de 1,3 GPa.

En outre des échantillons ainsi traités ont fait l'objet de tests de corrosion.

Un échantillon de cuivre pur à 99,99 % est d'abord poli avec un Ra de 0,02 µm.

L'échantillon est ensuite traité par implantation d'azote, afin d'obtenir le profil de concentration de la figure 3, sur une bande de sa surface.

L'échantillon est ensuite introduit dans une solution de NaCl à 30 g/l.

Après un séjour de 18 heures, de 24 heures, de 42 heures, la bande traitée de l'échantillon est dépourvue de toute trace de corrosion, alors que la bande non traitée est déjà corrodée après 18 heures, et extrêmement détériorée après 42 heures.

Un autre échantillon, traité de manière identique au précédent, a été immergé dans une solution HNO₃ 1M à 80 % pendant 5 secondes.

La bande traitée est indemne de toute trace de corrosion alors que la bande non traitée présente de fortes traces d'attaque, notamment aux joints de grain.

Afin d'illustrer d'autres remarquables propriétés de surface des matériaux selon l'invention, notamment pour des applications dans le domaine des contacts électriques, deux échantillons de cuivre à 99,99 % ont été préalablement polis (Ra de 0,02 microns) pour supprimer la couche d'oxyde superficiel.

Chaque échantillon a été traité selon l'invention sur une bande de leur surface et une bande est dépourvue de traitement. Un premier échantillon est traité de manière à obtenir une concentration atomique d'azote de 25 % sur une profondeur maximale de 0,15 µm et le deuxième échantillon est traité de manière à obtenir une concentration atomique d'azote de 38 % sur une profondeur maximale de 0,19 µm (selon la figure 3).

Les deux échantillons sont ensuite laissés à l'air libre pendant 21 jours à température ambiante.

On mesure alors la conductivité superficielle des deux échantillons en utilisant deux électrodes posées sur la surface à caractériser et reliées à un ohmmètre précis.

On constate que pour chacun des deux échantillons, la conductivité de la bande non traitée a considérablement diminué, démontrant une oxydation de ladite bande, alors que la bande traitée a conservé la conductivité du cuivre fraîchement coupé.

L'invention ne se limite pas à ces types de réalisation et doit être interprétée de façon non limitative, en englobant tout alliage de cuivre faiblement allié faiblement allié ayant les caractéristiques et/ou les propriétés décrites.

De même, le procédé selon l'invention n'est pas limité à l'utilisation d'une source RCE, et même si on peut penser que d'autres sources seraient moins avantageuses, on peut mettre en oeuvre le procédé selon l'invention, et obtenir des échantillons comprenant une couche de cuivre ou d'alliage de cuivre faiblement allié remarquable, avec des sources mono-zones ou d'autres sources multi-ions.

En résumé, on observe que le procédé de l'invention permet de ralentir considérablement l'oxydation du cuivre ou l'alliage de cuivre, en implantant sous la surface une barrière d'atomes d'azote, dont l'inertie chimique est avantageuse et qui semblent exercer une action de blocage en s'interposant entre le métal et l'oxygène. On ralentit ainsi fortement l'oxydation du cuivre ou les alliages de cuivre. On peut bloquer également la diffusion thermique des atomes de cuivre ou encore de ceux constituant l'alliage dans une pièce antagoniste au contact de laquelle la pièce selon l'invention peut être disposée : on réduit ainsi les risques de grippage provenant d'augmentations de température dues aux frottements.

A terme, on peut imaginer remplacer l'or pur réputé pour son inoxydabilité par du cuivre ou des alliages de cuivre faiblement alliés selon la présente invention qui présenteraient le triple avantage d'être meilleur conducteur que l'or, plus résistant mécaniquement et moins cher.

## Revendications

1. Pièce comprenant au moins une partie à la surface de laquelle est disposée une couche de cuivre ou d'alliage de cuivre faiblement allié comprenant des atomes d'azote insérés sur une épaisseur supérieure ou égale à 0,05 µm, par exemple supérieure ou égale à 0,1 µm, même par exemple supérieure ou égale à 0,2 µm, voire supérieure ou égale à 0,5 µm, où le profil de concentration de l'azote en fonction de l'épaisseur de la couche est une courbe résultant de la somme d'au moins deux courbes gaussiennes, où la composition de ladite couche est définie par les plages suivantes des teneurs des constituants majeurs suivants, exprimés en pourcentages pondéraux :
| | |
|---|---|
| Cuivre (Cu) | ≥ 97,5; |
| Oxygène (O) | 0 à 0,5 ; de préférence ≤ 0,1 ; |
| Cadmium (Cd) | 0 à 2,5 ; de préférence ≤ 1 ; |
| Argent (Ag) | 0 à 2,5 ; de préférence ≤ 0,5 ; par exemple ≤ 0,1 ; |
| Etain (Sn) | 0 à 2,5 ; de préférence ≤ 0,5 ; par exemple ≤ 0,15 ; |
| Tellure (Te) | 0 à 2,5 ; de préférence ≤ 1 ; |
| Soufre (S) | 0 à 2,5 ; de préférence ≤ 1 ; |
| Plomb | 0 à 2,5 ; de préférence ≤ 1 ; |
| Chrome (Cr) | 0 à 2,5 ; de préférence ≤ 1 ; |
| Zirconium (Zr) | 0 à 2,5 ; de préférence ≤ 0,2 ; |
| Phosphore (P) | 0 à 2,5 ; de préférence ≤ 0,1 ; |
| Fer (Fe) | 0 à 2,5 ; de préférence ≤ 1,5 ; |
| Cobalt (Co) | 0 à 2,5 ; de préférence ≤ 1 ; |
| Alumine (Al₂0₃) | 0 à 2,5 ; de préférence ≤ 1 ; |
| Oxyde de titane(Ti0₂) | 0 à 2,5 ; de préférence ≤ 1 ; |
où le pourcentage d'autres constituants dits mineurs est inférieur ou égal à 0,1, comprenant des atomes d'azote et dont la nano-dureté de surface est supérieure ou égale à 2 GPa, par exemple supérieure ou égale à 4 GPa, et /ou la dureté Vickers est supérieure ou égale à 200 pour une charge de 5 g, voire de 50 g.

2. Pièce selon la revendication précédente **caractérisée en ce que** la composition de l'alliage de cuivre faiblement allié peut comprendre également les constituants majeurs suivants dont la teneur est exprimée en pourcentages pondéraux :
| | |
|---|---|
| Silicium (Si) | 0 à 2,5 ; de préférence ≥ 0,5 ; et/ou de préférence ≤ 1 ; |
| Béryllium (Be) | 0 à 2,5 de préférence ≥ 0,5 ; et/ou de préférence ≤ 2 ; |
et la nano dureté de surface est supérieure ou égale à 5 GPa et/ou la durée Vickers est supérieure ou égale à 500 pour une charge de 5 g, voire de 50 g.

3. Pièce selon la revendication 1 ou 2 **caractérisée en ce que** la pièce ou une partie de la pièce est en cuivre ou en alliage de cuivre faiblement allié de même composition que la couche de cuivre ou d'alliage de cuivre faiblement allié comprenant des atomes d'azote et est en continuité de matière avec ladite pièce ou ladite partie de ladite pièce.

4. Pièce selon la revendication 1 ou 2 **caractérisée en ce que** la pièce est au moins partiellement revêtue de cuivre ou d'un alliage de cuivre faiblement allié et la couche de cuivre ou d'alliage de cuivre faiblement allié comprenant des atomes d'azote est en continuité de matière avec ledit revêtement.

5. Pièce selon l'une quelconque des revendications 1 à 4 **caractérisée en ce que** la pièce est une pièce d'un dispositif électrotechnique ou d'un circuit électrique et/ou électronique.

6. Pièce selon l'une quelconque des revendications précédentes, **caractérisée en ce que** la concentration atomique maximale N/(Cu+N) de la couche de cuivre ou d'alliage de cuivre faiblement allié, est supérieure ou égale à 5 %, par exemple supérieure ou égale à 10 %, voire supérieure ou égale à 20 % sur une épaisseur supérieure ou égale à 0,05 µm.

7. Pièce selon l'une quelconque des revendications précédentes **caractérisée en ce que** la concentration atomique N/(Cu+N) de la couche de cuivre ou d'alliage de cuivre faiblement allié est inférieure ou égale à 75 %, par exemple inférieure ou égale à 50 % sur l'ensemble de la profondeur de la couche de cuivre ou d'alliage comprenant des atomes d'azote insérés.

8. Pièce selon l'une quelconque des revendications précédentes **caractérisée en ce que** le profil de concentration de l'azote de la couche de cuivre ou d'alliage de cuivre faiblement allié présente un plateau sur une profondeur supérieure ou égale à 0,1 µm, par exemple supérieure ou égale à 0,2 µm.

9. Procédé de traitement d'un alliage de cuivre faiblement allié comprenant une étape d'implantation d'ions d'azote, émis par une source d'énergie supérieure ou égale à 10 keV par exemple supérieure ou égale à 20 keV, même par exemple supérieure ou égale à 30 keV, voire supérieure ou égale à 50 keV où les ions d'azote implantés sont des ions multi énergies, constitués de N+, N2+, N3+, N4+, et de N5+.

10. Procédé selon la revendication précédente **caractérisé en ce que** la source est une source à résonance cyclotronique électronique (RCE).

11. Procédé selon la revendication précédente **caractérisé en ce que** la source à résonance cyclotronique électronique délivre des ions accélérés par une tension d'extraction et des premiers moyens de réglage d'un faisceau initial d'ions émis par ladite source en un faisceau d'implantation.

12. Procédé selon l'une quelconque des revendications 9 à 11 **caractérisé en ce que** les ions d'azote multi énergies sont implantés simultanément à une profondeur contrôlée par la tension d'extraction de la source.

13. Procédé de traitement d'une pièce comprenant au moins une partie à la surface de laquelle est disposée une couche de cuivre ou d'alliage de cuivre faiblement allié et où ladite couche de cuivre ou d'alliage de cuivre faiblement allié est traitée selon l'une quelconque des revendications 9 à 12.

14. Procédé selon la revendication précédente **caractérisé en ce que** les ions d'azote sont des ions multi énergies et sont implantés dans la pièce à une température inférieure ou égale à 300° C.

15. Procédé selon l'une quelconque des revendications 13 ou 14 **caractérisé en ce que** le faisceau d'ions, notamment multi énergies, se déplace de façon relative par rapport à la pièce, par exemple à vitesse constante ou par exemple à une vitesse variable tenant compte de l'angle d'incidence du faisceau d'ions, par rapport à la surface de la pièce où est disposée la couche de cuivre ou d'alliage de cuivre faiblement allié à traiter.

## Patentansprüche

1. Teil, das mindestens einen Abschnitt umfasst, auf dessen Oberfläche eine Schicht aus Kupfer oder einer Kupferlegierung mit einem geringen Legierungsanteil mit integrierten Stickstoffatomen in einer Dicke von mehr als oder gleich 0,05 µm; zum Beispiel mehr als oder gleich 0,1 µm, oder zum Beispiel mehr als oder gleich 0,2 µm, oder sogar mehr als oder gleich 0,5 µm, aufgebracht ist,
wobei das Stickstoffkonzentrationsprofil als Funktion der Schichtdicke eine Kurve ist, die sich aus der Summe von mindestens zwei Gaußschen Kurven ergibt,
wobei die Zusammensetzung der besagten Schicht durch die folgenden Bereiche der folgenden Hauptkomponenten, angegeben in Gewichtsprozent, definiert ist:
| | |
|---|---|
| Kupfer (Cu) | ≥ 97,5 ; |
| Sauerstoff (0) | 0 bis 0,5 ; vorzugsweise ≤ 0,1 ; |
| Cadmium (Cd) | 0 bis 2,5 ; vorzugsweise ≤ 1 ; |
| Silber (Ag) | 0 bis 2,5 ; vorzugsweise ≤ 0,5 ; zum Beispiel ≤ 0,1 ; |
| Zinn (Sn) | 0 bis 2,5 ; vorzugsweise ≤ 0,5 ; zum Beispiel ≤ 0,15 ; |
| Tellur (Te) | 0 bis 2,5 ; vorzugsweise ≤ 1 ; |
| Schwefel (S) | 0 bis 2,5 ; vorzugsweise ≤ 1 ; |
| Blei | 0 bis 2,5 ; vorzugsweise ≤ 1 ; |
| Chrom (Cr) | 0 bis 2,5 ; vorzugsweise ≤ 1 ; |
| Zirconium (Zr) | 0 bis 2,5 ; vorzugsweise ≤ 0,2 ; |
| Phosphor (P) | 0 bis 2,5 ; vorzugsweise ≤ 0,1 ; |
| Eisen (Fe) | 0 bis 2,5 ; vorzugsweise ≤ 1,5 ; |
| Cobalt (Co) | 0 bis 2,5 ; vorzugsweise ≤ 1 ; |
| Aluminiumoxid (Al₂O₃) | 0 bis 2,5 ; vorzugsweise ≤ 1 ; |
| Titandioxid (TiO₂) | 0 bis 2,5 ; vorzugsweise ≤ 1 ; |
wobei der prozentuale Anteil anderer Nebenbestandteile weniger als oder gleich 0,1 beträgt, einschließlich der Stickstoffatome, und
wobei die Oberflächennanohärte mehr als oder gleich 2 GPa, zum Beispiel mehr als oder gleich 4 GPa beträgt, und/oder die Vickershärte mehr als oder gleich 200 bei einer Last von 5 g oder 50 g beträgt.

2. Teil gemäß dem vorherigen Anspruch, **dadurch gekennzeichnet, dass** die Zusammensetzung der Kupferlegierung mit einem geringen Legierungsanteil ferner die folgenden Hauptbestandteile, deren Gehalt in Gewichtsprozent angegeben ist, umfassen kann:
| | |
|---|---|
| Silicium (Si) | 0 bis 2,5 ; vorzugsweise ≥ 0,5 ; und/oder vorzugsweise ≤ 1 ; |
| Beryllium (Be) | 0 bis 2,5 vorzugsweise ≥ 0,5 ; und/oder vorzugsweise ≤ 2 ; |
und die Oberflächennanohärte mehr als oder gleich 5 GPa beträgt und/oder die Vickershärte mehr als oder gleich 500 bei einer Last von 5 g oder 50 g beträgt.

3. Teil gemäß Anspruch 1 oder 2, **dadurch gekennzeichnet, dass** das Teil oder ein Abschnitt des Teils aus Kupfer oder einer Kupferlegierung mit einem geringen Legierungsanteil mit derselben Zusammensetzung wie die Schicht aus Kupfer oder der Kupferlegierung mit einem geringen Legierungsanteil mit Stickstoffatomen ist und mit dem besagten Teil oder dem besagten Abschnitt von dem besagten Teil materialeinheitlich ist.

4. Teil gemäß Anspruch 1 oder 2, **dadurch gekennzeichnet, dass** das Teil mindestens teilweise mit Kupfer oder einer Kupferlegierung mit einem geringen Legierungsanteil überzogen ist und die Schicht aus Kupfer oder aus der Kupferlegierung mit einem geringen Legierungsanteil mit Stickstoffatomen mit dem besagten Überzug materialeinheitlich ist.

5. Teil gemäß einem der Ansprüche 1 bis 4, **dadurch gekennzeichnet, dass** das Teil ein Teil einer elektronischen Vorrichtung oder eines elektrischen und/oder elektronischen Schaltkreises ist.

6. Teil gemäß einem der vorherigen Ansprüche, **dadurch gekennzeichnet, dass** die maximale Atomkonzentration N/(Cu+N) der Schicht aus Kupfer oder der Kupferlegierung mit einem geringen Legierungsanteil mehr als oder gleich 5 %, zum Beispiel mehr als oder gleich 10 %, oder mehr als oder gleich 20 % in einer Dicke von mehr als oder gleich 0,05 µm, beträgt.

7. Teil gemäß einem der vorherigen Ansprüche, **dadurch gekennzeichnet, dass** die Atomkonzentration N/(Cu+N) der Schicht aus Kupfer oder der Kupferlegierung mit einem geringen Legierungsanteil weniger als oder gleich 75 %, zum Beispiel weniger als oder gleich 50 % in der gesamten Tiefe der Schicht aus Kupfer oder der Kupferlegierung mit einem geringen Legierungsanteil mit integrierten Stickstoffatomen beträgt.

8. Teil gemäß einem der vorherigen Ansprüche, **dadurch gekennzeichnet, dass** das Stickstoffkonzentrationsprofil der Schicht aus Kupfer oder der Kupferlegierung mit einem geringen Legierungsanteil ein Plateau in einer Tiefe von mehr als oder gleich 0,1 µm, zum Beispiel von mehr als oder gleich 0,2 µm, aufweist.

9. Verfahren zur Bearbeitung von Kupfer mit einem geringen Legierungsanteil, wobei das Verfahren einen Schritt des Inkorporierens von Stickstoffionen umfasst, die von einer Quelle mit einer Energie von mehr als oder gleich 10 keV zum Beispiel mehr als oder gleich 20 keV, oder zum Beispiel mehr als oder gleich 30 keV, oder sogar mehr als oder gleich 50 keV emittiert werden, wobei die inkorporierten Stickstoffionen Ionen mit mehreren Energien ("ions multi énergies") sind, bestehend aus N+, N2+, N3+, N4+ und N5+.

10. Verfahren gemäß dem vorherigen Anspruch, **dadurch gekennzeichnet, dass** die Quelle eine Elektron-Zyklotron-Resonanz-Quelle ist, (EZR).

11. Verfahren gemäß dem vorherigen Anspruch, **dadurch gekennzeichnet, dass** die Elektron-Zyklotron-Resonanz-Quelle durch eine Extraktionsspannung beschleunigte Ionen und die erste Steuerungseinrichtung eines von der Quelle emittierten Ausgangsionenstrahls als Inkorporierungsstrahl bereitstellt.

12. Verfahren gemäß einem der Ansprüche 9 bis 11, **dadurch gekennzeichnet, dass** die Stickstoffionen mit mehreren Energien ("ions multi énergies") gleichzeitig in einer durch die Extraktionsspannung der Quelle gesteuerte Tiefe inkorporiert werden.

13. Verfahren zur Bearbeitung eines Teils, das mindestens einen Abschnitt umfasst, auf dessen Oberfläche eine Schicht aus Kupfer oder einer Kupferlegierung mit einem geringen Legierungsanteil aufgebracht ist, und wobei besagte Schicht aus Kupfer oder der Kupferlegierung mit einem geringen Legierungsanteil gemäß einem der Ansprüche 9 bis 12 bearbeitet wird.

14. Verfahren gemäß dem vorherigen Anspruch, **dadurch gekennzeichnet, dass** die Stickstoffionen Ionen mit mehreren Energien ("ions multi énergies") sind und in das Teil bei einer Temperatur, die weniger als oder gleich 300°C beträgt inkorporiert werden.

15. Verfahren gemäß einem der Ansprüche 13 oder 14, **dadurch gekennzeichnet, dass** der Ionenstrahl, insbesondere mit mehreren Energien ("multi énergies"), sich relativ zu dem Teil bewegt, zum Beispiel mit einer konstanten Geschwindigkeit oder zum Beispiel mit einer variablen Geschwindigkeit unter Berücksichtigung des Einfallswinkel des Ionenstrahls auf der Oberfläche des Teils, auf der die zu bearbeitende Schicht aus Kupfer oder der Kupferlegierung mit einem geringen Legierungsanteil aufgebracht ist.

## Claims

1. Component comprising at least one part at the surface of which is positioned a layer of copper or of weakly alloyed copper alloy comprising nitrogen atoms inserted over a thickness of greater than or equal to 0.05 µm, for example of greater than or equal to 0.1 µm, even, for example, of greater than or equal to 0.2 µm, indeed even of greater than or equal to 0.5 µm, where the concentration profile of the nitrogen as a function of the thickness of the layer is a curve resulting from the sum of at least two Gaussian curves, where the composition of the said layer is defined by the following ranges of the contents of the following major constituents, expressed as percentages by weight:
| | |
|---|---|
| Copper (Cu) | ≥ 97.5; |
| Oxygen (O) | 0 to 0.5; preferably ≤ 0.1; |
| Cadmium (Cd) | 0 to 2.5; preferably ≤ 1; |
| Silver (Ag) | 0 to 2.5; preferably ≤ 0.5; for example ≤ 0.1; |
| Tin (Sn) | 0 to 2.5; preferably ≤ 0.5; for example ≤ 0.15; |
| Tellurium (Te) | 0 to 2.5; preferably ≤ 1; |
| Sulphur (S) | 0 to 2.5; preferably ≤ 1; |
| Lead | 0 to 2.5; preferably ≤ 1; |
| Chromium (Cr) | 0 to 2.5; preferably ≤ 1; |
| Zirconium (Zr) | 0 to 2.5; preferably ≤ 0.2; |
| Phosphorus (P) | 0 to 2.5; preferably ≤ 0.1; |
| Iron (Fe) | 0 to 2.5; preferably ≤ 1.5; |
| Cobalt (Co) | 0 to 2.5; preferably ≤ 1; |
| Alumina (Al₂O₃) | 0 to 2.5; preferably ≤ 1; |
| Titanium oxide (TiO₂) | 0 to 2.5; preferably ≤ 1; |
where the percentage of other "minor" constituents is less than or equal to 0.1, comprising nitrogen atoms and the surface nanohardness of which is greater than or equal to 2 GPa, for example greater than or equal to 4 GPa, and/or the Vickers hardness of which is greater than or equal to 200 for a load of 5 g, indeed even of 50 g.

2. Component according to the preceding claim, **characterized in that** the composition of the weakly alloyed copper alloy can also comprise the following major constituents, the content of which is expressed as percentages by weight:
| | |
|---|---|
| Silicon (Si) | 0 to 2.5; preferably ≥ 0.5; and/or preferably ≤ 1; |
| Beryllium (Be) | 0 to 2.5; preferably ≥ 0.5; and/or preferably ≤ 2; |
and the surface nanohardness of which is greater than or equal to 5 GPa and/or the Vickers hardness of which is greater than or equal to 500 for a load of 5 g, indeed even of 50 g.

3. Component according to Claim 1 or 2, **characterized in that** the component or a part of the component is made of copper or of weakly alloyed copper alloy of the same composition as the layer of copper or of weakly alloyed copper alloy comprising nitrogen atoms and is in continuity of material with the said component or the said part of the said component.

4. Component according to Claim 1 or 2, **characterized in that** the component is at least partially coated with copper or with a weakly alloyed copper alloy and the layer of copper or of weakly alloyed copper alloy comprising nitrogen atoms is in continuity of material with the said coating.

5. Component according to any one of Claims 1 to 4, **characterized in that** the component is a component of an electrical engineering device or of an electrical and/or electronic circuit.

6. Component according to any one of the preceding claims, **characterized in that** the N/(Cu+N) maximum atomic concentration of the layer of copper or of weakly alloyed copper alloy is greater than or equal to 5%, for example greater than or equal to 10%, indeed even greater than or equal to 20%, over a thickness of greater than or equal to 0.05 µm.

7. Component according to any one of the preceding claims, **characterized in that** the N/(Cu+N) atomic concentration of the layer of copper or of weakly alloyed copper alloy is less than or equal to 75%, for example less than or equal to 50%, over the whole of the depth of the layer of copper or of alloy comprising inserted nitrogen atoms.

8. Component according to any one of the preceding claims, **characterized in that** the concentration profile of the nitrogen of the layer of copper or of weakly alloyed copper alloy exhibits a plateau over a depth of greater than or equal to 0.1 µm, for example of greater than or equal to 0.2 µm.

9. Process for the treatment of a weakly alloyed copper alloy comprising a stage of implantation of nitrogen ions, emitted by an energy source of greater than or equal to 10 keV, for example of greater than or equal to 20 keV, even, for example, of greater than or equal to 30 keV, indeed even of greater than or equal to 50 keV, where the implanted nitrogen ions are multi-energy ions consisting of N+, N2+, N3+, N4+ and N5+.

10. Process according to the preceding claim, **characterized in that** the source is an electron cyclotron resonance (ECR) source.

11. Process according to the preceding claim, **characterized in that** the electron cyclotron resonance source delivers ions accelerated by an extraction voltage and first means for adjusting an initial beam of ions emitted by the said source to give an implantation beam.

12. Process according to any one of the Claims 9 to 11, **characterized in that** the multi-energy nitrogen ions are implanted simultaneously at a depth controlled by the extraction voltage of the source.

13. Process for the treatment of a component comprising at least one part at the surface of which is positioned a layer of copper or of weakly alloyed copper alloy and where the said layer of copper or of weakly alloyed copper alloy is treated according to any one of Claims 9 to 12.

14. Process according to the preceding claim, **characterized in that** the nitrogen ions are multi-energy ions and are implanted in the component at a temperature of less than or equal to 300°C.

15. Process according to either one of Claims 13 and 14, **characterized in that** the beam of ions, in particular multi-energy ions, moves relatively with respect to the component, for example at constant speed or, for example, at a speed which can vary taking into account the angle of incidence of the beam of ions, with respect to the surface of the component where the layer of copper or of weakly alloyed copper alloy to be treated is positioned.
